# EUROPÄISCHE PATENTSCHRIFT

(11) **EP 0 755 165 B1**
(45) Veröffentlichungstag und Bekanntmachung des Hinweises auf die Patenterteilung: **21.03.2001**
(21) Anmeldenummer: 96890125.6
(22) Anmeldetag: 15.07.1996
(51) Int. Cl.: H04R 1/06, H04M 1/03, H01R 13/24

(54) **Kontaktierung eines elektroakustischen Wandlers innerhalb eines Handapparates eines Fernsprechers**
Contacting of an electroacoustic transducer inside a telephone handset
Connexion d'un transducteur électro-acoustique à l'intérieur d'un combiné téléphonique

(30) Priorität: 17.07.1995 AT 121395
(43) Veröffentlichungstag der Anmeldung: 22.01.1997
(73) Patentinhaber: AKG Acoustics GmbH, 1230 Wien (AT)
(72) Erfinder: Hirtl, Franz, 2551 Enzesfeld (AT)
(74) Vertreter: Patentanwälte BARGER, PISO & PARTNER

(56) Entgegenhaltungen:
- EP-A- 0 490 214
- DE-B- 1 161 591
- DE-U- 9 407 781

## Beschreibung

Die Erfindung betrifft die Kontaktierung eines elektroakustischen Wandlers innerhalb eines Handapparates eines Fernsprechers, wobei der Wandler mit einer innerhalb des Handapparates angeordneten und elektrische Bauteile tragenden Leiterplatte elektrisch verbunden ist und geht aus von DE-U-94 07 781.

Besonders bei der Konstruktion von Mobil- oder Schnurlostelefonen werden möglichst kleine elektroakustische Wandler verwendet, da in dem Teil, der vom Benützer in der Hand gehalten wird, eine Reihe weiterer Baugruppen enthalten sein müssen. Dazu gehören beispielsweise der Sender- bzw. Empfangsteil, die Wahleinrichtungen, Anzeigeeinrichtungen, Verstärker für Hör- und Sprechseite, sowie Versorgungsschaltungen und ein aufladbarer Akku.

Die verwendeten elektroakustischen Wandler sind so im Handapparat montiert, daß sie durch Schallein- bzw. -austrittsöffnungen mit der Umgebung akustisch verbunden sind. Die Größe und Form dieser Schallein- und -austrittsöffnungen sowie die Verbindung der elektroakustischen Wandler mit dem Gehäuse sind wichtige akustische Parameter.

Darüber hinaus ist es notwendig, daß diese elektroakustischen Wandler mit der Elektronik des Telefons verbunden werden, um einerseits mit dem Hörsignal gespeist zu werden oder anderseits das Sprechsignal weiterzuleiten.

Diese Kontaktierung erfolgt meistens über Kontaktfahnen am elektroakustischen Wandler, an den mit einem Stecker Litzen angesteckt werden, deren anderes Ende dann mit der Leiterplatte, auf der die Elektronik montiert ist, verbunden werden müssen.

Es ist auch möglich, die Kontaktierung durch eine Lötverbindung auf der Wandlerseite und/oder auf der Leiterplattenseite herzustellen.

Die Kontaktfahnen selbst können auch als Lötstifte ausgebildet sein, die in die Leiterplatte direkt eingelötet werden. Diese Form der Kontaktierung ist im DE-GM 89 07 550 und unter Verwendung eines Dichttopfes im DE-GM 89 07 552 beschrieben.

Auch das Aufkleben von Wandlern auf eine Unterlage ist bekannt geworden. So wird in der DE-A-3 736 900 ein Verfahren beschrieben, bei dem ein piezoelektrischer Wandler mit einem elektrisch leitenden Kleber auf einer Folie, auf der auch Leiterbahnen angebracht sind, befestigt wird.

Diese Befestigungen sind zeitaufwendig und daher teuer.

Im DE-GM 94 07 781 wurde vorgeschlagen, den elektroakustischen Wandler mit Druckkontakten zu versehen, die die elektrische Verbindung zwischen elektroakustischem Wandler und Leiterplatte herstellen. Die vorgeschlagene Lösung verwendet Federbügel, die mehr oder minder zentral angeordnet sind, so daß sie gleichzeitig auch einen Druck auf den elektroakustischen Wandler ausüben, um diesen dicht in den Handapparateteil zu pressen.

Diese Konstruktion hat jedoch den Nachteil, daß durch die relativ große Kraft, die benötigt wird, den Wandler im Handapparat sicher festzuhalten, das Wandlergehäuse unsymmetrisch belastet wird. Weiters benötigt diese Konstruktion relativ viel Platz unter dem Wandler, der in modernen Geräten nicht zur Verfügung steht, da die Geräte möglichst dünn sein sollen. Aus Platzgründen werden daher besonders bei Mobil- und Schnurlostelefonen kleine miniaturisierte Wandler verwendet.

Die Erfindung vermeidet die erwähnten Nachteile dadurch, daß die elektrische Verbindung des Wandlers mit der Leiterplatte über Schraubenfedern erfolgt, die außerhalb der Membranfläche fest mit dem elektroakustischen Wandler verbunden sind. Dadurch ist es möglich, den Teil des elektroakustischen Wandlers, an dem die Schraubenfedern ansetzen, äußerst stabil auszuführen und diesen Teil auch noch im Handapparateteil separat zu unterstützen. Dadurch wird erreicht, daß auf die empfindlichen Teile des elektroakustischen Wandlers, an denen die Membran befestigt ist, kein unkontrollierter Druck ausgeübt wird.

Eine zweckmäßige Ausgestaltung der Erfindung besteht darin, daß die Schraubenfedern über im Wandler fix montierte Kontaktteile mit dem elektroakustischen Wandler verbunden sind. Ein im Wandler fix montierter Kontaktteil bietet ein gut kontaktierendes Auflager für die Feder und die Möglichkeit, das andere Ende des Kontaktteiles an die Bedürfnisse des jeweiligen Wandlers anzupassen. Ferner kann der Kontaktteil kostengünstig umspritzt werden und bildet ein festes Auflager für die Feder im Wandler.

Es ist vorteilhaft, wenn die Schraubenfedern an der Wandlerseite mit eingebogenen Enden versehen sind und an diesen eingebogenen Enden mit den im Wandler fix montierten Kontaktteilen verschweißt sind. Eine sichere Verbindung der Schraubenfedern mit dem Kontaktteil ist durch Verschweißung gewährleistet. Die Durchführung einer Verschweißung ist einfach möglich, wenn die Schraubenfeder ein eingebogenes Ende besitzt und der Kontaktteil von beiden Seiten zugänglich ist. Mit Schweißelektroden ist dann einerseits das eingebogene Ende der Schraubenfeder - durch die Schraubenfeder hindurch - und andererseits der Kontaktteil von der Oberseite erreichbar.

Wenn als elektroakustischer Wandler ein dynamischer Wandler verwendet wird, können die Enden der Tauchspule auch direkt mit den eingebogenen Enden der Kontaktfedern verbunden werden.

Nach einem weiteren Merkmal der Erfindung sind die Schraubenfedern mit den Enden der Tauchspule direkt verschweißt. Dies ist eine besonders kostengünstige und sichere Verbindungsmethode.

Schließlich ist es auch möglich, daß die Schraubenfedern vergoldet sind. Dadurch wird ein Schutz vor Korrosion bei schwierigen klimatischen Bedingungen und damit niedrige Kontaktwiderstände ermöglicht.

Eine weitere Ausgestaltung besteht darin, daß die Schraubenfedern an der Kontaktseite eine tote Windung aufweisen. Um den Kontakt zur Leiterplatte sicherzustellen, können die Schraubenfedern mit einer toten Windung ausgestattet sein, so daß eine größere Kontaktfläche und damit eine sichere Kontaktgabe erzielbar ist.

Es ist auch zweckmäßig, wenn die Enden der Schraubenfedern auf der Kontaktseite zur Leiterplatte hin gebogen sind, so daß sie sich in der Kontaktfläche der Leiterplatte verankern und dadurch eine Bewegung der Schraubenfeder quer zur Federungsrichtung verhindern.

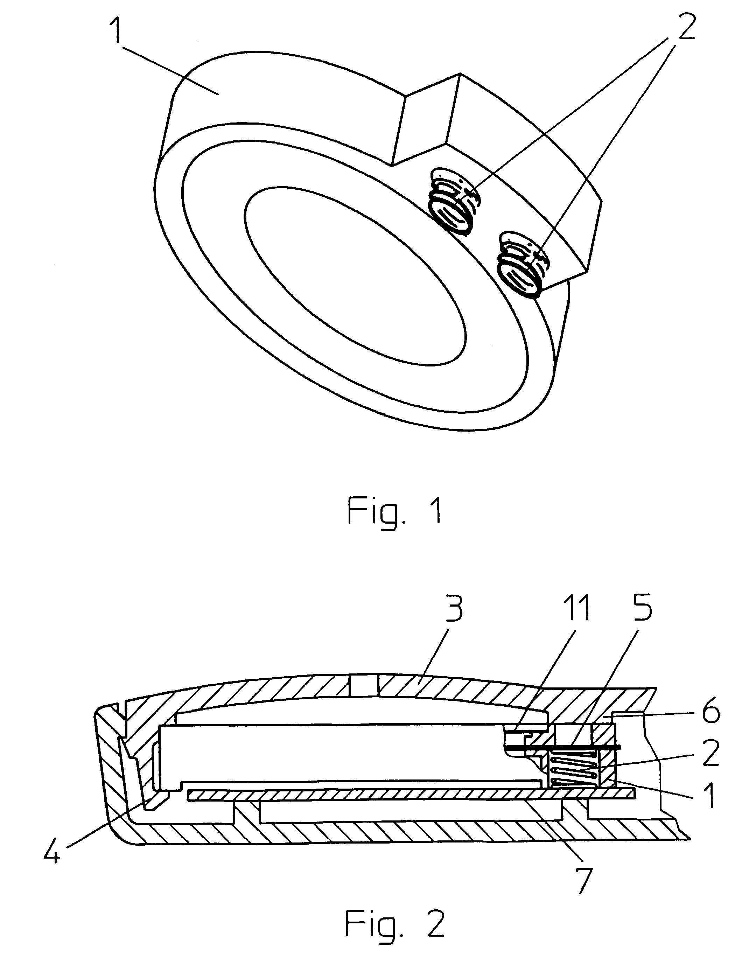

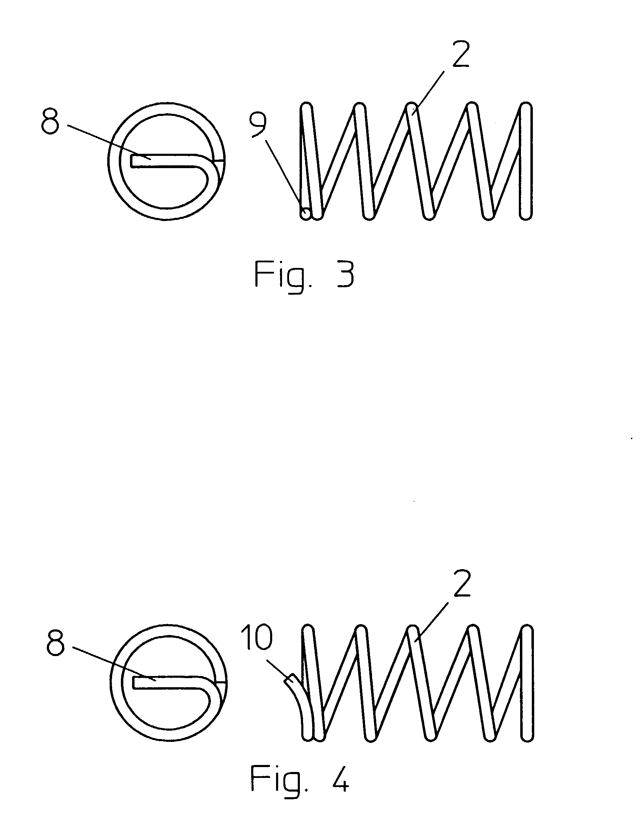

Die Erfindung wird an Hand der Zeichnung an einem bevorzugten Ausführungsbeispiel näher erläutert, u.zw. zeigen Fig. 1 einen erfindungsgemäßen elektroakustischen Wandler im Schrägriß, Fig. 2 den Querschnitt durch einen eingebauten elektroakustischen Wandler mit der zugehörigen Leiterplatte, Fig. 3 eine Kontaktfeder mit einem eingebogenen Ende und einer toten Windung auf der Leiterplattenseite und Fig. 4 eine Kontaktfeder wie in Fig. 3 dargestellt, jedoch mit einer Verformung des Federendes auf der Leiterplattenseite.

In Fig. 1 ist der elektroakustische Wandler im Schrägriß von der Kontaktseite gesehen dargestellt. Die Kontaktfedern 2 sind außerhalb der Membranfläche in der Kunststoffumspritzung 1 angeordnet.

Die Anordnung des elektroakustischen Wandler 1 im Handapparateteil 3 zeigt Fig. 2. Der elektroakustische Wandler wird durch eine ausreichende Anzahl von Schnapphaken 4 im Handapparateteil 3 gehalten. Die Kontaktfedern 2 sind außerhalb der Membranfläche 11 in der Kunststoffumspritzung 1 angeordnet und an einem Federende mit je einem Kontaktteil 5 verschweißt. Der Handapparateteil 3 ist so ausgebildet, daß sich im Bereich der Kontaktfedern 2 eine massive Unterstützung 6 des elektroakustischen Wandlers 1 ergibt. Dadurch ist es möglich, eine sichere Kontaktierung zu erhalten, ohne Gefahr zu laufen, durch eine zu große Kraft den elektroakustischen Wandler im Bereich des Membransitzes zu verformen. Die beiden anderen Enden der Kontaktfedern 2 ruhen auf Kontaktflächen der Leiterplatte 7, auf der die anderen elektrischen Bauteile befestigt sind.

Die Kontaktfedern 2 selbst sind so gestaltet, daß sie leicht mit dem Kontaktteil 5 verschweißt werden können. Dazu sind sie, wie Fig. 3 zeigt, auf der einen Seite mit einem eingebogenen Ende 8 versehen. Dadurch ist es möglich, eine Schweißelektrode durch die Kontaktfedern 2 hindurch zu führen und eine Verschweißung mit dem Kontaktteil 5, der auch von der anderen Seite zugänglich ist, vorzunehmen.

Wenn ein dynamischer Wandler verwendet wird, kann die Kontaktfeder 2 an ihrem eingebogenen Ende 8 auch direkt mit den Enden des Tauchspulendrahtes verschweißt werden.

Um eine große Kontaktfläche zur Leiterplatte zu gewährleisten, kann das andere Ende der Kontaktfeder als tote Windung 9 ausgebildet sein.

Eine besondere Ausbildung der Feder zeigt Fig. 4. Das Drahtende 10 ist in Richtung zur Leiterplatte hin verformt, so daß es sich durch den Druck der Kontaktfeder in der Leiterplatte 7 verankern kann. Dadurch wird eine Verschiebung der Kontaktfeder 2 quer zur Federungsrichtung wirksam verhindert.

Zur sicheren Kontaktierung auch unter schwierigen klimatischen Bedingungen sollte die Oberfläche vor Oxidationen geschützt werden. Durch Vergolden kann dieser Schutz bestens gewährleistet werden.

## Patentansprüche

1. Kontaktierung eines elektroakustischen Wandlers innerhalb eines Handapparates eines Fernsprechers, wobei der Wandler mit einer innerhalb des Handapparates angeordneten und elektrische Bauteile tragenden Leiterplatte elektrisch verbunden ist, dadurch gekennzeichnet, daß die elektrische Verbindung des Wandlers (1) mit der Leiterplatte (7) über Schraubenfedern (2) erfolgt, die außerhalb der Membranfläche (11) fest mit dem elektroakustischen Wandler (1) verbunden sind.

2. Kontaktierung nach Anspruch 1, dadurch gekennzeichnet, daß die Schraubenfedern (2) über im Wandler (1) fix montierte Kontaktteile (5) mit dem elektroakustischen Wandler (1) verbunden sind.

3. Kontaktierung nach Anspruch 2, dadurch gekennzeichnet, daß die Schraubenfedern (2) an der Wandlerseite mit eingebogenen Enden (8) versehen sind und an diesen eingebogenen Enden (8) mit den im Wandler (1) fix montierten Kontaktteilen (5) verschweißt sind.

4. Kontaktierung nach Anspruch 1, dadurch gekennzeichnet, daß der elektroakustische Wandler (1) ein dynamischer Wandler ist und die Schraubenfedern (2) direkt mit den Enden der Tauchspule verbunden sind.

5. Kontaktierung nach Anspruch 4, dadurch gekennzeichnet, daß die Schraubenfedern (2) mit den Enden der Tauchspule direkt verschweißt sind.

6. Kontaktierung nach einem der Ansprüche 1 bis 5, dadurch gekennzeichnet, daß die Schraubenfedern (2) vergoldet sind.

7. Kontaktierung nach einem der Ansprüche 1 bis 6, dadurch gekennzeichnet, daß die Schraubenfedern (2) an der Kontaktseite zur Leiterplatte eine tote Windung (9) aufweisen.

8. Kontaktierung nach einem der Ansprüche 1 bis 7, dadurch gekennzeichnet, daß die Enden (10) der Schraubenfedern (2) auf der Kontaktseite zur Leiterplatte hin gebogen sind, so daß sie sich in der Kontaktfläche der Leiterplatte (7) verankern und dadurch eine Bewegung der Schraubenfeder quer zur Federungsrichtung verhindern.

## Claims

1. Contacting an electroacoustic transducer inside a handset of a telephone, wherein the transducer is connected to a circuit board arranged inside the handset and carrying electrical components, characterised in that the electrical connection of the transducer (1) to the circuit board (7) takes place via helical springs (2) which are securely connected to the electroacoustic transducer (1) outside the diaphragm surface (11).

2. Contacting according to Claim 1, characterised in that the helical springs (2) are connected to the electroacoustic transducer (1) via contact members (5) firmly mounted in the transducer (1).

3. Contacting according to Claim 2, characterised in that, on the transducer side, the helical springs (2) are provided with inwardly bent ends (8) and contact members (5) firmly mounted in the transducer (1) are welded to these inwardly bent ends (8).

4. Contacting according to Claim 1, characterised in that the electroacoustic transducer (1) is a dynamic transducer and the helical springs (2) are connected directly to the ends of the moving coil.

5. Contacting according to Claim 4, characterised in that the helical springs (2) are directly welded to the ends of the moving coil.

6. Contacting according to any one of Claims 1 to 5, characterised in that the helical springs (2) are gold-plated.

7. Contacting according to any one of Claims 1 to 6, characterised in that the helical springs (2) have a dead winding (9) on the contact side to the circuit board.

8. Contacting according to any one of Claims 1 to 7, characterised in that the ends (10) of the helical springs (2) are bent on the contact side towards the circuit board so that they are anchored in the contact surface of the circuit board (7) and thereby prevent any movement of the helical spring transversely to the springing direction.

## Revendications

1. Système d'établissement de contact d'un transducteur électroacoustique à l'intérieur d'un combiné d'un téléphone, dans lequel le transducteur est relié électriquement à une plaquette à circuits imprimés qui est disposée à l'intérieur du combiné et porte des composants électriques, caractérisé en ce que la liaison électrique du transducteur (1) avec la plaquette à circuits imprimés (7) est réalisée par l'intermédiaire de ressorts hélicoïdaux (2), qui sont reliés de façon fixe, à l'intérieur de la surface (11) de la membrane, au transducteur électroacoustique (1).

2. Système d'établissement de contact selon la revendication 1, caractérisé en ce que les ressorts hélicoïdaux (2) sont reliés au transducteur électroacoustique (1) par l'intermédiaire de pièces de contact (5) qui sont montées de façon fixe dans le transducteur (1).

3. Système d'établissement de contact selon la revendication 2, caractérisé en ce que les ressorts hélicoïdaux (2) sont équipés, au niveau de la face du transducteur, d'extrémités repliées vers l'intérieur (8) et sont soudés, au niveau de ces extrémités repliées vers l'intérieur (8), aux pièces de contact (5) montées de façon fixe dans le transducteur (1).

4. Système d'établissement de contact selon la revendication 1, caractérisé en ce que le transducteur électroacoustique (1) est un transducteur dynamique et que les ressorts hélicoïdaux (2) sont reliés directement aux extrémités de la bobine mobile.

5. Système d'établissement de contact selon la revendication 4, caractérisé en ce que les ressorts hélicoïdaux (2) sont soudés directement aux extrémités de la bobine mobile.

6. Système d'établissement de contact selon les revendications 1 à 5, caractérisé en ce que les ressorts hélicoïdaux (2) sont plaqués d'or.

7. Système d'établissement de contact selon les revendications 1 à 6, caractérisé en ce que les ressorts hélicoïdaux (2) possèdent une spire morte (9) du côté de la face de contact de la plaquette à circuits imprimés.

8. Système d'établissement de contact selon l'une des revendications 1 à 7, caractérisé en ce que les extrémités (10) des ressorts hélicoïdaux (2) sont repliées du côté de la face de contact en direction de la plaquette à circuits imprimés, de sorte qu'ils sont ancrés dans la surface de contact de la plaquette à circuits imprimés (7) et, de ce fait, empêchent un déplacement des ressorts hélicoïdaux transversalement par rapport à la direction de débattement élastique.
